# EUROPÄISCHE PATENTSCHRIFT

(11) **EP 1 247 432 B1**
(45) Veröffentlichungstag und Bekanntmachung des Hinweises auf die Patenterteilung: **05.03.2008**
(21) Anmeldenummer: 00991628.9
(22) Anmeldetag: 22.12.2000
(51) Int. Cl.: H05B 41/282, H05K 1/16, H05K 1/14

(54) **ELEKTRONISCHES VORSCHALTGERÄT UND ELEKTRONISCHER TRANSFORMATOR**
ELECTRONIC BALLAST AND ELECTRONIC TRANSFORMER
BALLAST ET TRANSFORMATEUR ELECTRONIQUES

(30) Priorität: 27.12.1999 DE 19963292
(43) Veröffentlichungstag der Anmeldung: 09.10.2002
(60) Teilanmeldung: 06015508.2
(73) Patentinhaber: TridonicAtco GmbH & Co. KG, 6850 Dornbirn (AT)
(72) Erfinder: HEIN, Peter, A-6833 Fraxern (AT)
(74) Vertreter: Rupp, Christian
(86) Internationale Anmeldenummer: PCT/EP2000/013170
(87) Internationale Veröffentlichungsnummer: WO 2001/049083

(56) Entgegenhaltungen:
- EP-A- 0 581 206
- EP-A- 0 690 460
- WO-A-96/07297
- DE-A- 4 126 544
- DE-A- 19 848 834
- US-A- 5 371 440
- US-A- 5 604 673
- US-A- 5 768 109
- US-A- 5 945 902
- PATENT ABSTRACTS OF JAPAN & JP 09 162230 A (TAIYO YUDEN CO), 20. Juni 1997 (1997-06-20)

## Beschreibung

Die Erfindung betrifft ein elektronisches Vorschaltgerät zum Betreiben einer Elektroden aufweisenden Entladungslampe bzw. einen elektronischen Transformator zum Betreiben einer Niedervolt-Halogenlampe. Dabei weist das Vorschaltgerät bzw. der Transformator LTCC- (Low Temperature Cofired Ceramic) Mehrlagenkomponenten auf.

Dem Konstrukteur von elektronischen Vorschaltgeräten drängt sich zunächst die Überlegung auf, ein von ihm zu konstruierendes Vorschaltgerät mit Netzfrequenz zu betreiben, da die Netzfrequenz vorhanden ist. Dabei zeigt sich jedoch, daß die Bauelemente relativ groß gewählt werden müssen. Das hat zur Folge, daß das Vorschaltgerät nicht nur teuer wird, sondern außerdem noch relativ große Abnützungen hat.

Die Vorschaltgeräte-Konstrukteure sind daher sehr bald dazu übergegangen, für den Betrieb der Vorschaltgeräte höhere Frequenzen zu verwenden, um Bauelemente mit geringeren Abmessungen verwenden zu können, mit der Folge, daß auch das Vorschaltgerät kleiner und billiger wurde. Hierbei wird zwar in Kauf genommen, daß die Netzspannung zunächst gleichgerichtet werden muß und daß aus der gleichgerichteten Netzspannung eine höherfrequente Wechselspannung erzeugt werden muß; die geschilderten Vorteile überwiegen jedoch im Hinblick auf den dadurch bedingten Mehraufwand. Hinzu kommt ein weiterer Vorteil, nämlich der, daß der Wirkungsgrad von Niederdruck-Entladungslampen bei höheren Frequenzen ansteigt.

Als Optimum für die Wahl von Zünd- und Betriebsfrequenzen bei elektronischen Vorschaltgeräten wurde bisher der Bereich zwischen 20 und 50 kHz angesehen. Dies deshalb, weil in diesem Bereich noch die Störstrahlungen beherrschbar sind, die die Vorschaltgeräte einerseits ins Netz abstrahlen und die andererseits durch die Antennenwirkung der Lampe direkt in die Umgebung gestrahlt werden. Die zulässigen Abstrahlungs-Werte sind durch Normen geregelt.

Der erwähnte Frequenzbereich von 20-50 kHz hat sich auch insofern als optimal erwiesen, als die Abmessungen der sich dadurch ergebenden diskreten Bauelemente noch groß genug sind, um sich für eine automatisch Bestückung auf Leiterplatten zu eignen. Allerdings ist durch den genannten Frequenzbereich in der Vorschaltgeräte-Entwicklung auch eine gewisse Stagnation eingetreten.

Im Gegensatz zu elektronischen Vorschaltgeräten für Gasentladungslampen bieten elektronischen Transformatoren zum Betreiben von Niedervolt-Halogenlampen zunächst keinen Vorteil, wenn man ausschließlich das Verhalten der Niedervolt-Halogenlampen betrachtet. Vorteile resultieren allerdings in den Möglichkeiten, die sich aus der Anwendung elektronischer Schaltungen ergeben.

So kann auch ohne aufwendige Regler die Abhängigkeit der Ausgangsspannung von der Last und der Netzspannung gegenüber konventionellen Transformatoren verbessert werden. Darüber hinaus können bei elektronischen Transformatoren alle derzeit üblichen Verfahren zum Dimmen der Lampen zum Einsatz kommen. Schließlich kann mit Hilfe eines geregelten Systems - unabhängig von den äußeren Gegebenheiten - ein optimaler Betrieb erzielt werden. Dies ist vor dem Hintergrund interessant, daß der Lichtstrom und die Lebensdauer von Niedervolt-Halogenlampen sehr stark spannungsabhängig sind.

In gleicher Weise wie bei den elektronischen Vorschaltgeräten hat sich auch bei der Entwicklung der elektronischen Transformatoren zum Betreiben von Niedervolt-Halogenlampen ein Frequenzbereich zwischen 20 und 50 kHz als bevorzugt herausgestellt. Auch hier ist im Laufe der Zeit eine gewisse Stagnation in der Weiterentwicklung eingetreten.

Aus der deutschen Offenlegungsschrift DE 41 26 544 A1 ist ein elektronischer Halbwellenconverter zur Speisung einer Niedervolt-Halogenlampe bekannt. Dabei liegt die Betriebsfrequenz oberhalb von 100 kHz, beispielsweise bei 200 kHz.

In der US Patentschrift 5,949,191 ist ein elektronisches Vorschaltgerät für Entladungslampen beschrieben. Der Zündtransformator dieses Vorschaltgeräts weist dabei gedruckte Schaltungen in Mehrlagen-Technologie auf.

Der Erfindung liegt deshalb die Aufgabe zugrunde, die bisher für ein Optimum gehaltenen Frequenzgrenzen für elektronische Vorschaltgeräte und elektronische Transformatoren zu sprengen und in der Entwicklung und dabei insbesondere der Miniaturisierung dieser Geräte neue Wege zu gehen.

Gemäß einem ersten Aspekt der Erfindung wird die Aufgabe dadurch gelöst, daß der Wechselrichter eines elektronischen Vorschaltgeräts nunmehr zum Zünden und im Betrieb der Lampe mit Frequenzen oberhalb von 200 kHz betrieben wird und daß passive Bauelemente des Vorschaltgeräts in eine Mehrlagenschaltung integriert sind. Vorzugsweise wird der Wechselrichter mit Frequenzen oberhalb von 1 MHz betrieben, insbesondere zwischen 2,2 MHz und 3,0 MHz.

Gegenüber dem bisher für optimal gehaltenen Frequenzbereich ist damit ein erheblicher Frequenzsprung gemacht worden, wobei es nicht selbstverständlich ist, daß Entladungslampen bei derartig hohen Frequenzen von ihren physikalischen Bedingungen her noch einwandfrei arbeiten. Es hat sich jedoch gezeigt, daß die Lampen bei diesen Frequenzen nicht nur arbeiten; vielmehr hat sich herausgestellt, daß sie sogar leichter gezündet werden können und daß auch der Wirkungsgrad noch gesteigert werden kann. Weiterhin hat sich gezeigt, daß Befürchtungen, daß eine bei derartig hohen Frequenzen betriebene Lampe einer sie berührenden Person einen Schlag versetzen könnte, nicht zutreffen.

Der Einsatz derart hoher Frequenzen im Lampenbetrieb ist ansatzweise bereits bekannt. So beschreibt die US 5,371,440 ein elektronisches Vorschaltgerät, bei dem die gleichgerichtete Netz-Versorgungsspannung zunächst in eine hochfrequente Wechselspannung mit einer Frequenz von 1-2 MHz umgesetzt und darüber hinaus mit einer Frequenz von ca. 20 kHz moduliert wird. Bevor diese Wechselspannung der zu betreibenden Lampe zugeführt wird, wird sie allerdings nochmals geglättet, so daß die Lampe wiederum lediglich mit einer Frequenz in dem bekannten Bereich von ca. 20-50 kHz betrieben wird.

Bei einem aus der WO 96/07297 A2 bekannten Vorschaltgerät hingegen wird dem Lastkreis tatsächlich eine Wechselspannung mit einer Frequenz von 2,65 MHz zugeführt. Allerdings werden für den Lampenbetrieb besondere Vorkehrungen getroffen. So wird ein bestimmtes Verhältnis zwischen der Resonanzfrequenz des Lastkreises und der Frequenz des Wechselrichters gewählt, welches einen besonders effektiven Betrieb gewährleistet. Darüber hinaus ist dieses Vorschaltgerät insbesondere für elektroden-lose Lampen geeignet.

Um bei den erfindungsgemäß hohen Frequenzen die Abstrahlung von elektromagnetischen Hochfrequenz-Feldern in die Umgebung möglichst niedrig zu halten, ist es erstrebenswert, das Vorschaltgerät kompakt zu gestalten, da in diesem Fall in einfacher Weise Abschirmmaßnahmen getroffen werden können. Durch die Erhöhung der Betriebsfrequenz können jedoch die Kapazitäts- und Induktivitätswerte von einigen in dem Vorschaltgerät verwendeten Bauteilen derart reduziert werden, daß anstelle der Verwendung von diskreten Bauelementen erfindungsgemäß eine Integrierung dieser Elemente in eine Mehrlagenschaltung erfolgen kann. Insbesondere passive Bauelemente wie Widerstände, Kapazitäten. Transformatoren oder Drosseln bieten sich dabei für die Integrierung an, so daß eine deutliche Reduzierung der Abmessungen des gesamten Vorschaltgerätes erreicht werden kann.

Dabei können sämtliche Arten von Entladungslampen verwendet werden, z.B. herkömmliche Niederdruck-Entladungslampen. Ein bevorzugtes Anwendungsbeispiel sind allerdings sog. Kompaktlampen, beispielsweise Elektroden aufweisende, einseitig gesockelte Leuchtstofflampen oder Hochdruck-Gasentladungslampen. Diese haben den Vorteil, daß aufgrund des einseitigen Sockels die elektrischen Zuleitungen deutlich kürzer gestaltet werden können als bei einer zweiseitig gesockelten Lampe und dementsprechend die Abstrahlung reduziert wird.

Gemäß einem zweiten Aspekt der vorliegenden Erfindung wird die Aufgabenstellung auch durch einen elektronischen Transformator zum Betreiben einer Niedervolt-Halogenlampe gelöst, der einen mit Gleichspannung gespeisten und in seiner Ausgangsfrequenz variierbaren Wechselrichter aufweist, sowie einen an den Ausgang des Wechselrichters angeschlossenen Lastkreis, der mindestens einen Transformator und eine an die Sekundärwicklung des Transformators angeschlossene Niedervolt-Halogenlampe enthält. Erfindungsgemäß wird der Wechselrichter wiederum bei Frequenzen oberhalb von 200 kHz betrieben und passive Bauelemente des elektronischen Transformators sind in eine Mehrlagenschaltung integriert.

Wie auch bei dem erfindungsgemäßen elektronischen Vorschaltgerät wird erst durch die deutliche Erhöhung der Betriebsfrequenz die Möglichkeit eröffnet, Teile des elektronischen Transformators zu integrieren und diesen damit insgesamt kompakter zu gestalten. Vorzugsweise wird der Wechselrichter mit einer Frequenz oberhalb von 1 MHz betrieben, besonders bevorzugt zwischen 2,3 MHz und 3,0 MHz. Dieser Bereich ist insofern besonders vorteilhaft, als die europäischen Normen hier eine erhöhte Störabstrahlung zulassen.

Weiterbildungen der Erfindung sind Gegenstand der Unteransprüche.

Die Integrierung von Bauelementen kann beispielsweise durch eine mehrlagige Leiterplatten-Technik erfolgen. Vorzugsweise wird die Mehrlagenschaltung durch eine LTCC- (Low Temperature Cofired Ceramic) Struktur realisiert, welche aus mehreren übereinander angeordneten niedrig sinternden Keramikschichten oder -folien besteht, zwischen denen sich Leiterbahnen befinden. Gegenüber der herkömmlichen Leiterptattentechnik kann mit dieser in den letzten Jahren neu entwickelten LTCC-Technik eine nochmalige Miniaturisierung der Schaltung erreicht werden. Dabei können neben den Leiterbahnen insbesondere auch Induktivitäten und Kapazitäten in die Mehrlagenschaltungen integriert werden. Ferner bietet das Keramik-Material den Vorteil, daß es Wärme relativ gut leitet, was bedeutet, daß bei gleichem Bauvolumen größere Leistungen erzielt werden können, da Verlustwärme besser abgestrahlt wird. Vorzugsweise wird die Wärmeableitung durch Einbetten der Keramikstruktur in ein metallisches Gehäuse nochmals erhöht. Auf diese Weise kann auch eine effektive Abschirmung der von dem Vorschaltgerät in die Umgebung abgestrahlten Hochfrequenz-Felder erzielt werden. Solche LTCC-Mehrlagenschaltungen sind in allgemeiner Form in der EP 0 581 206 A2 oder der US 5,945,902 beschrieben.

Bei Betriebsfrequenzen im Megahertz-Bereich kann ein Großteil der Bauelemente des Vorschaltgerätes in die Mehrlagenschaltung integriert werden. Die verbleibenden passiven Bauelemente sowie einige Halbleiter-Baugruppen sind allerdings nach wie vor an der Oberfläche bzw. außerhalb der Keramikstruktur anzubringen. Um auch hierfür einen möglichst geringen Platzbedarf zu erzielen, werden die Halbleiter-Baugruppen vorzugsweise mittels der - beispielsweise aus der EP 0 690 460 A1 bekannten - Flip-Chip- (FC) Technik auf dem Keramiksubstrat montiert. Dabei wird zwischen dem gehäuselos montierten Halbleiter sowie den Kontakten auf der Oberfläche des Trägersubstrats eine Kunststoffschicht eingebracht, die zum einen senkrecht zur Kontaktierungsebene elektrisch leitfähig und in der Kontaktierungsebene isolierend wirkt und die zum anderen die sich bei einer unterschiedlichen thermischen Ausdehnung der Halbleiterbaugruppe und des Keramiksubstrats ergebenden Spannungen aufnimmt und somit eine Zerstörung der Halbleiterbaugruppe verhindert.

Durch die vorliegende Erfindung werden somit ein kompaktes Vorschaltgerät bzw. ein kompakter elektronischer Transformator angegeben, die aufgrund ihrer Eigenschaften einen zuverlässigen und sicheren Betrieb von Entladungslampen bzw. Niedervolt-Halogenlampen ermöglichen.

Im folgenden soll die Erfindung anhand der beiliegenden Zeichnungen näher erläutert werden. Es zeigen:
- Fig. 1: den schaltungstechnischen Aufbau eines erfindungsgemäßen elektronischen Vorschaltgeräts zum Betreiben einer Entladungslampe;
- Fig. 2: ein bevorzugtes Anwendungsbeispiel einer einseitig gesockelten Entladungslampe;
- Fig.3: den schaltungstechnischen Aufbau eines erfindungsgemäßen elektronischen Transformators zum Betreiben einer Niedervolt-Halogenlampe;
- Fig. 4a-9: die Fertigungsschritte einer Mehrlagen-Keramik- (LTCC) Struktur; und
- Fig. 10: einen vergrößerten Ausschnitt einer LTCC-Struktur.

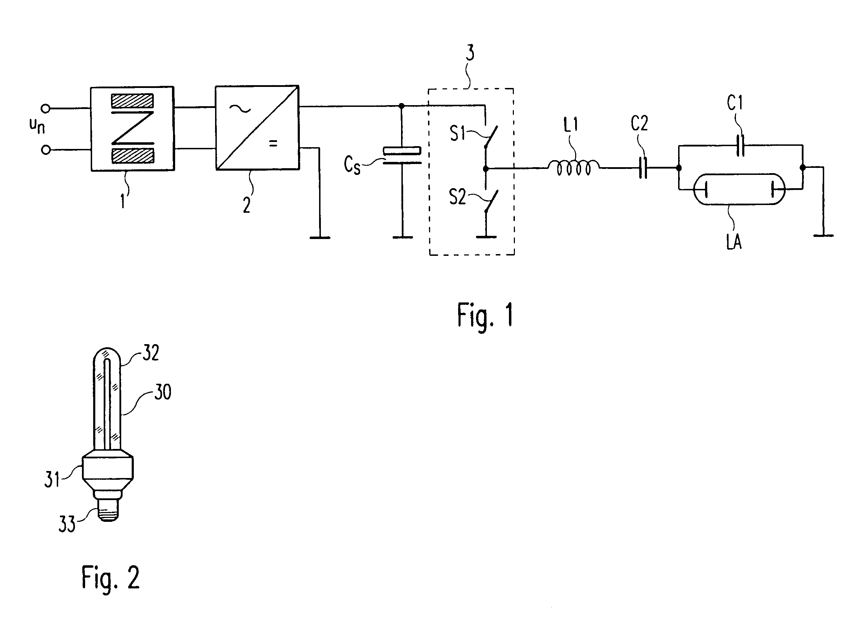

Fig. 1 zeigt das typische Funktionsschaltbild eines einfachen elektronischen Vorschaltgerätes. Den mit der Netzwechselspannung uₙ verbundenen Eingang des Vorschaltgerätes bildet ein Oberwellenfilter 1, das als Funkschutzfilter die durch die Schaltvorgänge im Vorschatgerät entstehenden und auf das Versorgungsnetz übergreifenden Störspannungen begrenzen soll. An den Ausgang des Oberwellenfilters 1 ist eine Gleichrichterschaltung 2 - beispielsweise ein Brückengleichrichter oder dgl. - angeschlossen. Zum Glätten der gleichgerichteten Netzwechselspannung uₙ befindet sich zwischen dem positiven Ausgang der Gleichrichterschaltung 2 und dem Eingang des Wechselrichters 3 ein als Speicherkondensator fungierender Elektrolytkondensator Cₛ.

Im vorliegenden Beispiel wird der Wechselrichter 3 des Vorschaltgeräts durch eine Halbbrücke aus zwei in Serie geschalteten elektronischen Schaltern S 1 und S2 gebildet, wobei ein Schalter jeweils aus einem MOS-Feldeffekttransistor bestehen kann. Das Ansteuern dieser beiden Schalter S1 bzw. S2 erfolgt über eine nicht dargestellte Steuerschaltung derart, daß jeweils einer der beiden Schalter S1 oder S2 geöffnet und der andere geschlossen ist, wobei erfindungsgemäß die Schaltfrequenz oberhalb von 200 kHz liegt, vorzugsweise oberhalb von 1 MHz und besonders bevorzugt im Bereich zwischen 2,2 und 3,0 MHz, beispielsweise bei ca. 2,65 MHz.

An den Ausgang des Wechselrichters 3, d.h. an den gemeinsamen Knotenpunkt der beiden Schalter S 1 und S2 ist der die Entladungslampe LA enthaltende Lastkreis angeschlossen. Dieser besteht aus einem Serienresonanzkreis, der sich aus einer Drosselspule L1 und einem Resonanzkondensator C1 zusammensetzt. Zwischen der Drosselspule L1 und dem Resonanzkondensator C1 ist ferner ein Koppelkondensator C2 angeordnet. An den Verbindungsknoten zwischen den beiden Kondensatoren C1 und C2 ist eine der beiden Kathoden der Entladungslampe LA angeschlossen, so daß die Lampe LA parallel zu dem Resonanzkondensator C1 liegt. Bei der Lampe LA kann es sich beispielsweise um eine Niederdruck-Entladungslampe handeln. Vorzugsweise handelt es sich um eine Elektroden aufweisende, einseitig gesockelte Leuchtstofflampe oder Hochdruck-Gasentladungslampe, da in diesem Fall die Abstrahlung von der Lampe reduziert wird.

Der in Fig. 1 dargestellte Schaltungsaufbau ist bereits durch die herkömmlichen Vorschaltgeräte, mit denen Entladungslampen in einem Frequenzbereich zwischen 20 kHz und 50 kHz betrieben werden, hinlänglich bekannt und muß daher nicht weiter erläutert werden. Insbesondere der Induktivitätswert der Drosselspule L1 sowie die Kapazitätswerte des Resonanzkondensators C1 und des Koppelkondensators C2 sind bei dem erfindungsgemäßen Vorschaltgerät aufgrund der hohen Betriebsfrequenzen jedoch deutlich niedriger als die entsprechenden Werte bei einem herkömmlichen Vorschaltgerät. Die drei eben genannten passiven Bauteile müssen daher nicht mehr als diskrete Bauelemente vorliegen, sondern können in eine Mehrlagenschaltung integriert werden.

Die in Fig. 1 dargestellte Schaltung kann ohne weiteres ergänzt werden. So wäre es z.B. denkbar, durch geeignete Schaltungen, welche den Lampenstrom und die Lampenspannung erfassen, den Betriebszustand der Lampe LA zu überwachen. Ferner wäre es möglich, durch die Verwendung eines Heiztransformators die Lampenelektroden vor dem Zünden der Lampe LA vorzuheizen. Wie allerdings bereits erwähnt wurde, zeigen sich die herkömmlichen Gasentladungslampen bei den erfindungsgemäßen Betriebsfrequenzen überraschenderweise äußerst zündwillig, so daß der Einsatz einer entsprechenden Elektrodenheizung für den Lampenstart nicht zwingend notwendig ist.

Fig. 2 zeigt das bevorzugte Anwendungsbeispiel einer Elektroden aufweisenden, einseitig gesockelten Lampe 30, welche üblicherweise auch als Kompakflampe bezeichnet wird. Die Hauptkomponenten dieser Kompaktlampe 30 sind ein Basiskörper 31, von dem sich in der einen Richtung eine U-förmige Gasentladungsröhre 32 und in der entgegengesetzten Richtung ein Sockel 33 erstreckt. Der Sockel 33 ist für die Aufnahme in einer üblichen Glühbirnen-Fassung vorgesehen, innerhalb des Basiskörpers 31 ist das elektronische Vorschaltgerät angeordnet. Aufgrund der erfindungsgemäßen Integration der passiven Bauelemente in eine Mehrlagenschaltung können die Abmessungen des Vorschaltgeräts sehr klein gehalten werden, so daß dieses auch in kleinen Basiskörpern Platz findet.

Ein weiterer Vorteil in der Verwendung einer solchen Kompaktlampe 30 besteht auch darin, daß aufgrund des einseitigen Sockels die elektrischen Zuleitungen deutlich kürzer gestaltet werden können als bei einer zweiseitig gesockelten Lampe. Da dementsprechend die hochfrequente Wechselspannung auch nur an einem kurzen Leitungsabschnitt anliegt, wird die Abstrahlung insgesamt reduziert. Bei der einseitig gesockelten Kompaktlampe 30 kann es sich sowohl um eine Leuchstofflampe als auch um eine Hochdruck-Gasentladungslampe handeln.

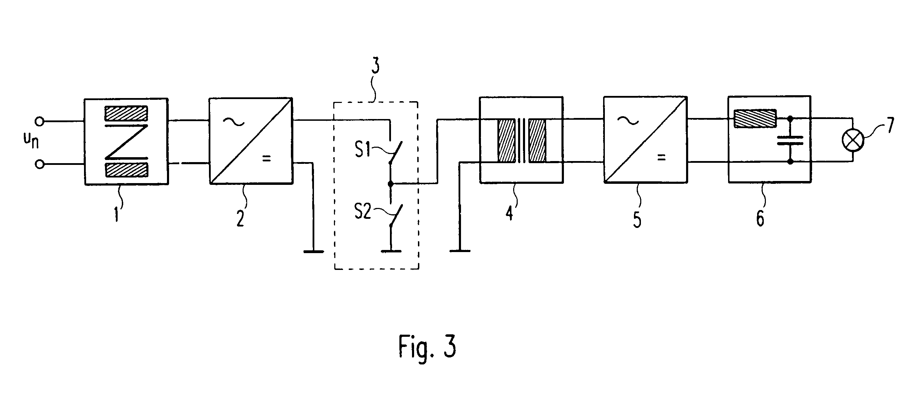

Als Ausführungsbeispiel für den zweiten Aspekts der vorliegenden Erfindung zeigt Fig. 3 das typische Funktionsschaltbild eines elektronischen Transformators zum Betreiben ein Niedervolt-Halogenlampe, wobei Elemente, welche zu den in Fig. 1 dargestellten Bauelementen identisch sind, mit den gleichen Bezugszeichen versehen sind. Zunächst weist auch der elektronische Transformator ein Oberwellenfilter 1 zur Funkentstörung auf, welches eingangsseitig an eine Wechselspannungsquelle angeschlossen ist, die eine Versorgungswechselspannung uₙ abgibt. An das Oberwellenfilter 1 schließt sich eine Gleichrichterschaltung 2 an, welche die von ihr erzeugte gleichgerichtete Versorgungswechselspannung an einen Wechselrichter 3 abgibt, der wiederum aus zwei in einer Halbbrückenschaltung angeordneten Schaltern S1 und S2 besteht.

Die Schalter S1, S2 werden nach einem bestimmten Schema von einer - wiederum nicht dargestellten - Steuerschaltung abwechselnd ein- und ausgeschaltet, so daß sich auf diese Weise eine in Rechteckblöcke zerhackte Spannung ergibt, die mit der gleichgerichteten Netzspannung moduliert ist. Die so erzeugte Wechselspannung wird mittels eines Übertragers 4 auf einen ausgangsseitigen Lastkreis übertragen und dabei auf eine für die in dem Lastkreis angeordnete Niedervolt-Halogenlampe 7 notwendige Kleinspannung transformiert. Ferner befindet sich in dem Lastkreis eine weitere Schaltung 5 zum Gleichrichten sowie ein Filter 6 zum Glätten der übertragenen Wechselspannung.

Wiederum werden die Schalter S1 und S2 des Wechselrichters 3 erfindungsgemäß mit einer Frequenz oberhalb von 200 kHz betrieben, so daß eine deutliche Reduzierung der Induktivitäts- und Kapazitätswerte der in der Schaltung enthaltenen passiven Bauelemente erzielt wird und diese somit in eine Mehrlagenschaltung integriert werden können. Vorzugsweise liegen die Frequenzen oberhalb von 1 MHz, besonders bevorzugt im Bereich zwischen 2,2 MHz und 3,0 MHz, beispielsweise bei ca. 2,65 MHz. Ergänzungen der Schaltung durch weitere Überwachungsschaltungen oder Regelschaltungen zum Dimmen der Niedervolt-Halogenlampe 7 können ebenfalls vorgesehen sein.

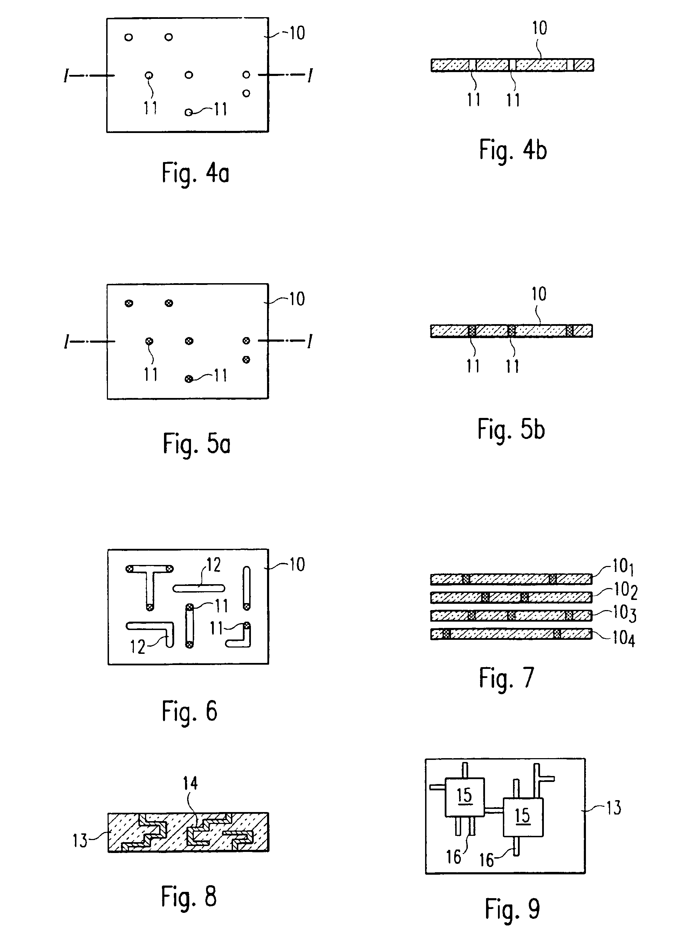

Im folgenden soll näher auf den strukturellen Aufbau des Vorschaltgerätes bzw. des elektronischen Transformators eingegangen werden. Für die Integrierung der passiven Bauelemente bietet sich insbesondere die bereits erwähnte LTCC-Mehrlagenschaltung an. Die Herstellung einer derartigen Keramik-Mehrlagenstruktur soll nun anhand der Figuren 4a-9 erläutert werden.

Den Grundbaustein einer LTCC-Struktur bildet eine ca. 100-130 µm dicke niedrig sinternde Keramikfolie - beispielsweise aus Aluminiumoxid, das mit Glaspartikeln und weiterem Füller-Material vermischt ist - wie sie in Fig. 4a in Draufsicht gezeigt ist. Der erste Bearbeitungsschritt besteht darin, in die Keramikfolie 10 Durchkontaktierungslöcher 11 zu stanzen. Fig. 4b zeigt die entsprechend bearbeitete Keramikfolie 10 im Schnitt 1-1 der Fig. 4a. Vor dem Brennprozess beträgt der Durchmesser der Durchkontaktierungslöcher 11 in etwa 250 µm. Im nächsten in den Figuren 5a und 5b dargestellten Arbeitsschritt werden die Durchkontaktierungslöcher 11 dann mit einem leitfähigem Material, üblicherweise mit einer Leiterpaste, die einen relativ hohen Feststoffanteil enthält, gefüllt.

Entsprechend der gewünschten schaltungstechnischen Struktur werden dann auf die Oberseite der Keramikfolie 10 Leiterbahnen 12 aufgedruckt (Fig. 6). Dies erfolgt üblicherweise mittels Siebdruckverfahren. Dabei werden für die Durchkontaktierungen und für die Leiterbahnen Silber-, Silber/Palladium-, Gold- oder Kupferpasten verwendet. Um Durchbiegungen zu vermeiden wird die Materialzusammensetzung der Leiterpasten so gewählt, daß diese beim späteren Sintern in gleichem Maße wie die Keramikschichten 10 selbst schrumpfen.

Die eben beschriebenen Bearbeitungsschritte werden zunächst für jede Keramikfolie 10 getrennt durchgeführt. Die einzelnen Lagen gestanzter und bedruckter Keramikfolien 10 werden dann übereinander angeordnet und ausgerichtet, wie dies in Fig. 7 gezeigt ist. Anschließend werden sie in einer Pressform gestapelt und unter Zuführung von Wärme und Druck laminiert, so daß sich eine zusammenhängende Keramikstruktur bildet. Diese wird schließlich zu einer hochfesten Keramikstruktur gesintert, wobei sich - wie in Fig. 8 gezeigt ist - ein homogenes Keramiksubstrat 13 mit einem darin integrierten zusammenhängenden Leiterbahnen-Netz 14 bildet.

In dem in Fig. 9 gezeigten abschließenden Bearbeitungsschritt werden dann die nicht in die Keramikstruktur integrierbaren Bauteile, beispielsweise diverse Halbleiterbaugruppen 15 sowie der in Fig. 1 gezeigte Elektrolytkondensator Cₛ an der Oberseite des Keramiksubstrats 13 befestigt und kontaktiert. Dabei können nachträglich auch auf die Oberseite Leiterbahnen 16 aufgebracht werden. Schließlich wird der gesamte Komplex mit Anschlüssen versehen und mit einem metallischen Gehäuse umgeben, das zum einen die Wärmeableitung erhöht und zum anderen die während des Betriebs entstehenden hochfrequenten elektromagnetischen Felder abschirmt.

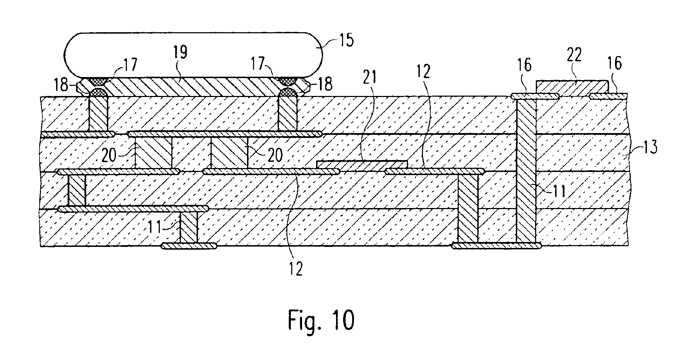

Fig. 10 zeigt nochmals in vergrößerter Darstellung einen Bereich der LTCC-Struktur im Schnitt. Dabei sind noch die Trennlinien zwischen den einzelnen ursprünglichen Keramikschichten eingezeichnet, auch wenn sich - wie zuvor beschrieben - nach dem Laminieren und Sintern eine homogene Keramikstruktur 13 bildet. Wie auf der rechten Seite der Abbildung zu sehen ist, können sich dabei die vertikal verlaufenden Leiterbahnen 11, die durch die im ersten Verfahrensschritt herausgestanzten Durchkontaktierungslöcher gebildet werden, auch über mehrere Ebenen erstrecken. Der wesentliche Vorteil der Verwendung einer LTCC-Struktur besteht darin, daß nicht nur Leiterbahnen 11 bzw. 12 sondern auch andere passive Bauelemente in die Mehrlagenschaltung integriert werden können. Im Rahmen des in Fig. 6 gezeigten Bearbeitungsschrittes können neben der Leiterpaste für die allgemeinen Leiterbahnen 12 beispielsweise auch andere Materialien mit bestimmter Leitfähigkeit auf die Oberseite einer einzelnen Keramikschicht 10 aufgebracht werden, so daß auf diese Weise ein Widerstand 21 vollkommen in die Keramikstruktur 13 integriert werden kann. Neben den üblichen Durchkontaktierungslöchern 11 können aber beispielsweise auch größere vertikal verlaufende Löcher in eine Keramikschicht 10 eingestanzt werden. Diese können dann mit einem Material 20 mit einer bestimmten Dielektrizitätskonstante gefüllt werden, so daß durch die in Fig. 10 gezeigten Schichtanordnung Leiterbahn - Dielektrikum 20 - Leiterbahn in das Keramiksubstrat 13 integrierte Kapazitäten realisiert werden können. Beispielsweise können auf diese Weise der in Figur 1 gezeigte Resonanzkondensator C1 und der Koppelkondensator C2 in die Mehrlagenschaltung 13 integriert werden.

Nicht dargestellt ist die Integration der in Fig. 1 gezeigten Resonanzdrossel L1, die ebenfalls denkbar wäre. Beispielsweise könnte eine Induktivität innerhalb der Keramikstruktur 13 durch eine auf eine einzelne Keramikschicht 10 aufgedruckte spiralenartige Leiterbahnen realisiert werden. Denkbar wäre allerdings auch, die verschiedenen Wicklungen der Induktivität auf mehrere Leiterbahn-Ebenen zu verteilen. Derartige Strukturen werden auch als planare Induktivitäten bezeichnet. Zur Erhöhung der Induktivität, könnte ferner auch eine Öffnung oder Ausnehmung in dem Keramiksubstrat 13 vorgesehen werden, die mit einem geeigneten Kern-Material, beispielsweise Ferrit, gefüllt wird. Insbesondere durch die Integration von Induktivitäten kann nochmals eine deutliche Reduzierung der Größe des gesamten Vorschaltgerätes bzw. elektronischen Transformators erzielt werden.

Für die in die Mehrlagenschaltung integrierten Bauelemente können nur Induktivitäts- und Kapazitätswerte bis zu einer bestimmten Höhe erreicht werden. Diese Werte sind allerdings für einen ordnungsgemäßen Betrieb des Vorschaltgerätes bzw. des elektronischen Transformators bei den erfindungsgemäßen Frequenzen ausreichend.

Allerdings können bei der LTCC-Technik nicht sämtliche Bauelemente in die Mehrlagenschaltung 13 integriert werden. Beispielsweise muß für den Speicherkondensator Cₛ nach wie vor ein Elektrolytkondensator als diskretes Bauteil verwendet werden. Dieser wird dann nach dem Sintern des Keramiksubstrats 13 an dessen Oberfläche montiert. In gleicher Weise können selbstverständlich auch Widerstände 22 oder Induktivitäten an der Oberfläche angebracht werden. Insbesondere Steuerschaltungen zum Ansteuern der beiden Schalter S1 uns S2 des Wechselrichters sowie evtl. Überwachungsschaltungen werden im wesentlichen durch Halbleiter-Baugruppen 15 gebildet, die nicht in die Keramikschicht 13 integriert werden können. Vorzugsweise werden dann solche Halbleiter-Baugruppen 15 an der Oberseite der Mehrlagenschaltung 13 mittels Flip-Chip-Technik kontaktiert. Dabei wird zwischen die Oberseite des Keramiksubstrats 13 und die ungehäuste Halbleiterschaltung 15 ein anisotrop elektrisch leitender Kunststoff eingebracht, der senkrecht zur Flip-Chip-Kontaktierungsebene elektrisch leitfähig und in der Kontaktierungsebene isolierend wirkt. Als elektrisch leitende Partikel enthält der Kunststoff beispielsweise unregelmäßig geformte Metallstückchen oder aber auch kleinere Kügelchen oder Fasern, welche eine Kontaktierung zwischen den Oberflächenkontakten 18 des Keramiksubstrats 13 und den Anschlußpads 17 der Halbleiterbaugruppe 15 bewirken. Ferner nimmt dieser Kunststoff 18 auch Spannungen auf, die sich durch eine unterschiedlich thermische Ausdehnung des Keramikmaterials und der Halbleiterbaugruppe 15 ergeben können. Diese Flip-Chip-Technik ermöglicht eine sehr hohe Kontaktierungsdichte, so daß sie ebenfalls zu einer Volumenreduzierung des gesamten Vorschaltgerätes beiträgt.

Es wurde somit ein Konzept für ein elektronisches Vorschaltgerät bzw. einen elektronischen Transformator vorgestellt, mit dem herkömmliche Niederdruck-Entladungslampen, Leuchstofflampen und Hochdruck-Gasentladungslampen bzw. Niedervolt-Halogenlampen mit einem hohen Wirkungsgrad betreiben werden können und das ferner in einer sehr kompakten Form realisiert werden kann. Diese kompakte Form wiederum bietet die Möglichkeit, geeignete Abschirmmaßnahmen gegen die bei den hohen Frequenzen auftretenden elektromagnetischen Felder vorzunehmen.

Die weit verbreiteten Vorbehalte, daß ein Betrieb von Elektroden aufweisenden Entladungslampen bei den Höchstfrequenzen entsprechend der Erfindung sehr gefährlich oder gar nicht möglich ist, haben sich als unbegründet erwiesen. Darüber hinaus hat sich überraschenderweise ergeben, daß die herkömmlichen Entladungslampen bei diesen hohen Frequenzen nicht nur ohne Schwierigkeiten betrieben werden können, sondern möglicherweise auch noch wesentlich einfacher, als dies bisher bekannt war, gezündet werden können, so daß zusätzlich ein vereinfachter Schaltungsaufbau denkbar ist.

## Patentansprüche

1. Elektronisches Vorschaltgerät zum Betrieb einer Elektroden aufweisenden Entladungslampe (LA) mit
einem mit Gleichspannung gespeisten und in seiner Ausgangsfrequenz variierbaren Wechselrichter (S1, S2) und
einem an den Ausgang des Wechselrichters (S1, S2) angeschlossenen Lastkreis, der mindestens einen Serienresonanzkreis (L1, C1) und mindestens eine Entladungslampe (LA) enthält,
**dadurch gekennzeichnet,**
- **daß** der Wechselrichter (S1, S2) zum Zünden und im Betrieb bei Frequenzen oberhalb von 200 kHz betrieben wird,
- **daß** das Vorschaltgerät mindestens eine Mehrlagenschaltung (13) aufweist, in die passive Bauelemente (20, 21) des Vorschaltgerätes integriert sind, wobei die Mehrlagenschaltung eine LTCC-Mehrlagenschaltung mit gesinterten Keramikschichten (13) ist, und
- **daß** Halbleiterbaugruppen (15) auf der Oberfläche der Mehrlagenschaltung (13) mittels Flip-Chip-Technologie befestigt sind, wobei zwischen der Oberseite der Mehrlagenschaltung (13) und den Halbleiterbaugruppen (15) ein anisotrop elektrisch leitender Kunststoff (19) angeordnet ist.

2. Elektronisches Vorschaltgerät nach Anspruch 1,
**dadurch gekennzeichnet,**
**daß** der Wechselrichter (S1, S2) zum Zünde n und im Betrieb bei Frequenzen oberhalb von 1 MHz betrieben wird.

3. Elektronisches Vorschaltgerät nach Anspruch 1,
**dadurch gekennzeichnet,**
**daß** es sich bei der Lampe um eine Elektroden aufweisende, einseitig gesockelte Leuchtstofflampe oder Hochdruck-Gasentladungslampe handelt.

4. Elektronischer Transformator zum Betrieb einer Niedervolt-Halogenlampe (7) mit
einem mit Gleichspannung gespeisten und in seiner Ausgangsfrequenz variierbaren Wechselrichter (S1, S2) und
einem an den Ausgang des Wechselrichters (S1, S2) angeschlossenen Lastkreis, der mindestens einen Transformator (4) und eine an die Sekundärwicklung des Transformators (4) angeschlossene Niedervolt-Halogenlampe (7) enthält,
**dadurch gekennzeichnet,**
- **daß** der Wechselrichter (S1, S2) bei Frequenzen oberhalb von 200 kHz betrieben wird,
- **daß** der elektronische Transformator eine LTCC-Mehrlagenschaltung mit gesinterten Keramikschichten (13) aufweist, in die passive Bauelemente (20, 21) des elektronischen Transformators integriert sind, und
- **daß** Halbleiterbaugruppen (15) auf der Oberfläche der Mehrlagenschaltung (13) mittels Flip-Chip-Technologie befestigt sind, wobei zwischen der Oberseite der Mehrlagenschaltung (13) und den Halbleiterbaugruppen (15) ein anisotrop elektrisch leitender Kunststoff (19) angeordnet ist.

5. Elektronischer Transformator nach Anspruch 4,
**dadurch gekennzeichnet,**
**daß** der Wechselrichter (S1, S2) bei Frequenzen oberhalb von 1 MHz betrieben wird.

6. Elektronisches Vorschaltgerät oder elektronischer Transformator nach einem der vorherigen Ansprüche,
**dadurch gekennzeichnet,**
**daß** die Frequenz des Wechselrichters (S1, S2) zumindest im Betrieb zwischen 2,2 MHz und 3,0 MHz liegt.

7. Elektronisches Vorschaltgerät oder elektronischer Transformator nach einem der vorherigen Ansprüche,
**dadurch gekennzeichnet,**
**daß** insbesondere Drosseln (L1) in Form von planaren Induktivitäten in die Mehrlagenschaltung integriert sind.

8. Elektronisches Vorschaltgerät oder elektronischer Transformator nach einem der vorherigen Ansprüche,
**dadurch gekennzeichnet,**
**daß** eine Mehrlagenschaltung aus mehreren übereinander angeordneten Leiterplatten besteht, an deren Ober- und/oder Unterseiten Leiterbahnen aus einem leitfähigen Material aufgebracht sind und die zum Verbinden von verschiedenen Leitungsebenen Durchkontaktierungslöcher aufweisen, die ebenfalls mit einem leitfähigen Material gefüllt sind.

9. Elektronisches Vorschaltgerät oder elektronischer Transformator nach einem der vorherigen Ansprüche,
**dadurch gekennzeichnet,**
**daß** die Mehrlagenschaltung (13) von einem metallischen Gehäuse umgeben ist.

10. Elektronisches Vorschaltgerät oder elektronischer Transformator nach einem der vorherigen Ansprüche,
**dadurch gekennzeichnet,**
**daß** der Kunststoff (19) senkrecht zur Flip-Chip-Kontaktierungsebene leitfähig ist und in der Kontaktierungsebene isolierend wirkt.

11. Elektronisches Vorschaltgerät oder elektronischer Transformator nach einem der vorherigen Ansprüche,
**dadurch gekennzeichnet,**
**daß** die mittel Flip-Chip-Technologie befestigten Halbleiterbaugruppen (15) ungehäust sind.

## Claims

1. Electronic ballast for operating a discharge lamp (LA) having electrodes, having
an inverter (S1, S2) fed with d.c. voltage and variable in its output frequency and
a load circuit connected to the output of the inverter (S1, S2), which load circuit contains at least one series resonant circuit (L1, C1) and at least one discharge lamp (LA),
**characterised in that**,
- for ignition and in operation the inverter (S1, S2) is operated at frequencies above 200 kHz,
- **in that** the ballast has at least one multi-layer circuit (13) into which passive components (20, 21) of the ballast are integrated, wherein the multi-layer circuit is an LTCC multi-layer circuit having sintered ceramic layers (13), and
- **in that** semiconductor component groups (15) on the surface of the multi-layer circuit (13) are attached by means of flip chip technology, wherein between the upper side of the multi-layer circuit (13) and the semiconductor component groups (15) there is arranged an anisotropically electrically conducting plastic (19).

2. Electronic ballast according to claim 1,
**characterised in that**,
for ignition and in operation the inverter (S1, S2) is operated at frequencies above 1 MHz.

3. Electronic ballast according to claim 1,
**characterised in that**,
the lamp is a single-ended fluorescent lamp or high pressure gas-discharge lamp having electrodes.

4. Electronic transformer for operating a low volt halogen lamp (7) having
an inverter (S1, S2) fed with d.c. voltage and variable in its output frequency and
a load circuit connected to the output of the inverter (S1, S2), which load circuit contains at least one transformer (4) and a low volt halogen lamp (7) connected to the secondary winding of the transformer (4),
**characterised in that**,
- the inverter (S1, S2) is operated at frequencies above 200 kHz,
- **in that** the transformer has an LTCC multi-layer circuit having sintered ceramic layers (13), into which the passive components (20, 21) of the electronic transformer are integrated, and
- **in that** semiconductor component groups (15) on the surface of the multi-layer circuit (13) are attached by means of flip chip technology, wherein between the upper side of the multi-layer circuit (13) and the semiconductor component groups (15) there is arranged an anisotropically electrically conducting plastic (19).

5. Electronic transformer according to claim 4,
**characterised in that**,
the inverter (S1, S2) is operated at frequencies above 1 MHz.

6. Electronic ballast or electronic transformer according to any preceding claim,
**characterised in that**,
the frequency of the inverter (S1, S2) is, at least in operation, between 2.2 MHz and 3.0 MHz.

7. Electronic ballast or electronic transformer according to any preceding claim,
**characterised in that**,
in particular chokes (L1) are integrated into the multi-layer circuit in the form of planar inductances.

8. Electronic ballast or electronic transformer according to any preceding claim,
**characterised in that**,
a multi-layer circuit is comprised of a plurality of circuit boards arranged above one another, on the upper and/or undersides of which conductor paths of a conductive material are applied and which have through-contacting holes for the connection of different conductor planes, with holes are likewise filled with a conductive material.

9. Electronic ballast or electronic transformer according to any preceding claim,
**characterised in that**,
the multi-layer circuit (13) is surrounded by a metallic housing.

10. Electronic ballast or electronic transformer according to any preceding claim,
**characterised in that**,
the plastic (19) is conductive perpendicularly to the flip chip contacting plane and acts in insulating manner in the contacting plane.

11. Electronic ballast or electronic transformer according to any preceding claim,
**characterised in that**,
the semiconductor component groups (15) attached by means of flip-chip technology are not housed.

## Revendications

1. Ballast électronique pour faire fonctionner une lampe à décharge (LA) présentant des électrodes et comportant :
- un onduleur (S1, S2) alimenté par une tension continue et ayant une fréquence de sortie variable et
- un circuit de charge connecté à la sortie de l'onduleur (S1, S2), lequel circuit de charge comprend au moins un circuit série raisonnant (L1,C1) et au moins une lampe à décharge (LA),
**caractérisé en ce que**
- l'onduleur (S1, S2) est utilisé pour l'allumage et en fonctionnement à des fréquences supérieures à 200 kHz,
- le ballast présente au moins un circuit multicouche (13), dans lequel sont intégrés des composants électroniques passifs (20, 21) du ballast, le circuit multicouche étant un circuit multicouche LTCC avec des couches de céramique vitrifiée (13), et
- des modules de semi-conducteurs (15) sont fixés sur la surface du circuit multicouche (13) à l'aide de la technologie Flip-Chip, une matière plastique (19) anisotrope et conducteur de courant étant disposée entre le côté supérieur du circuit multicouche (13) et les modules de semi-conducteur (15).

2. Ballast électronique selon la revendication 1,
**caractérisé en ce que** l'onduleur (S1, S2) est utilisé pour l'allumage et en fonctionnement à des fréquences supérieures à 1 MHz.

3. Ballast électronique selon la revendication 1,
**caractérisé en ce que** la lampe est une lampe fluorescente ou une lampe à décharge luminescente sous haute pression, présentant des électrodes et ayant un culot d'un côté.

4. Transformateur électronique pour faire fonctionner une lampe à halogène basse tension (7) avec
- un onduleur (S1, S2) alimenté par une tension continue et ayant une fréquence de sortie variable et
- un circuit de charge connecté à la sortie de l'onduleur (S1, S2), lequel circuit de charge comprend au moins un transformateur (4) et une lampe à halogène basse tension (7) connectée à l'enroulement secondaire du transformateur (4),
**caractérisé en ce que**
- l'onduleur (S1, S2) est utilisé à des fréquences supérieures à 200 kHz,
- le transformateur électronique présente un circuit multicouche LTCC avec des couches de céramique vitrifiée (13), dans lequel sont intégrés des composants électroniques passifs (20, 21) du transformateur électronique, et
- des modules de semi-conducteurs (15) sont fixés sur la surface du circuit multicouche (13) à l'aide de la technologie Flip-Chip, une matière plastique (19) anisotrope et conducteur de courant étant disposée entre le côté supérieur du circuit multicouche (13) et les modules de semi-conducteur (15).

5. Transformateur électronique selon la revendication 4,
**caractérisé en ce que** l'onduleur (S1, S2) est utilisé à des fréquences supérieures à 1 MHz.

6. Ballast électronique ou transformateur électronique selon l'une des revendications précédentes,
**caractérisé en ce que** la fréquence de l'onduleur (S1, S2) soit comprise au moins en fonctionnement entre 2,2 MHz et 3,0 MHz.

7. Ballast électronique ou transformateur électronique selon l'une des revendications précédentes,
**caractérisé en ce que** notamment des inductances (L1) sous forme d'inductances planes sont intégrées dans le circuit multicouche.

8. Ballast électronique ou transformateur électronique selon l'une des revendications précédentes,
**caractérisé en ce que** un circuit multicouche est composé de plusieurs circuits imprimés
disposés l'un sur l'autre, sur le côté supérieur et/ ou inférieur desquels sont montés des pistes conductrices d'un matériau conducteur et lesquels présentent des trous de montage transversal pour relier différents niveaux de conducteur, lesquels trous de montage transversal sont également remplis d'un matériau conducteur.

9. Ballast électronique ou transformateur électronique selon l'une des revendications précédentes,
**caractérisé en ce que** le circuit multicouche (13) est entouré d'un boîtier métallique.

10. Ballast électronique ou transformateur électronique selon l'une des revendications précédentes,
**caractérisé en ce que** le matériau plastique (19) est isolant perpendiculairement au plan de contact Flip-Chip et agit comme isolant dans le plan de contact.

11. Ballast électronique ou transformateur électronique selon l'une des revendications précédentes,
**caractérisé en ce que** les modules de semi-conducteurs (15) fixés par la technologie FLIP-CHIP sont hors boîtier.
